# EUROPÄISCHE PATENTANMELDUNG

(11) **EP 4 096 080 A1**
(43) Veröffentlichungstag der Anmeldung: **30.11.2022**
(21) Anmeldenummer: 21176647.2
(22) Anmeldetag: 28.05.2021
(51) Int. Cl.: H02M 1/32, H02H 3/24, G01R 19/165

(54) **SCHALTUNGSANORDNUNG UND VERFAHREN ZUR ERKENNUNG EINER VERSORGUNGSSPANNUNG**

(71) Anmelder: Siemens Aktiengesellschaft, 80333 München (DE)
(72) Erfinder: Riech, Markus, 92286 Rieden (DE)

(57) **Zusammenfassung**

Die Erfindung betrifft eine Schaltungsanordnung und ein Verfahren zur Erkennung, ob eine an Eingangskontakten (2, 3) eines Geräts (1) anliegende Versorgungsspannung (U₀) einen vorgegebenen Schwellwert überschreitet, wobei die Versorgungsspannung (U0) auf einem ersten Leitungspfad (P1) einen geräteinternen Energiespeicher (C1) lädt und eine durch den besagten Energiespeicher (C1) gepufferte Eingangsgröße einer Steuereinheit (CU) des Geräts (1) bildet, welche in Abhängigkeit von einer Höhe dieser Eingangsgröße einen Aktor (A) des Geräts (1) steuert. Es wird auf Basis der an den Eingangskontakten (2, 3) des Geräts (1) anliegenden Versorgungsspannung (U0) auf einem parallel zum ersten Leitungspfad (P1) verlaufenden zweiten Leitungspfad (P2) unter Umgehung des Energiespeichers (C1) ein Ausgangssignal (S) erzeugt, welches anzeigt, ob die an den Eingangskontakten (2, 3) anliegende Versorgungsspannung (U0) einen vorgegebenen Schwellwert überschreitet oder nicht. Das Ausgangssignal (S) wird der Steuereinheit (CU) zugeführt, welche in Abhängigkeit von dem Ausgangssignal (S) den Aktor (A) ansteuert.

## Beschreibung

Die Erfindung betrifft eine Schaltungsanordnung zur Erkennung einer Versorgungsspannung für ein Gerät, ein Gerät mit einer solchen Schaltungsanordnung sowie ein Verfahren zur Erkennung, ob eine an Eingangskontakten eines Geräts anliegende Versorgungsspannung einen vorgegebenen Schwellwert überschreitet.

Ein mit einer externen Versorgungsspannung betriebenes Gerät besitzt oftmals einen geräteinternen Energiespeicher, der so groß bemessen ist, dass die Spannungsversorgung des Gerätes im Falle eines vorübergehenden Einbruchs der Versorgungsspannung überbrückt und so der durchgehende Betrieb des Gerätes sicherstellt werden kann. Der Energiespeicher kann dabei als Pufferkondensator, auch als Stützkondensator bezeichnet, ausgebildet sein. Solche Schaltungen sind z. B beschrieben in WO2014/032718A1 (Siemens AG) 06.03.2014 und WO2014/075743A1 (Siemens AG) 22.05.2014.

Ein solcher Energiespeicher kann eine unerwünscht lange Verzögerung zwischen einer absichtlichen Abschaltung der Versorgungsspannung und einer entsprechenden geräteinternen Reaktion bewirken: erst wenn sich der Energiespeicher weitgehend selbst bis auf ein bestimmtes Spannungsniveau entladen hat, erkennt eine interne Elektronik des Gerätes am abgefallenen Spannungsniveau das Abschalten des Geräts selbstständig und kann entsprechende Reaktionen, z.B. das Schalten eines Relais, veranlassen. Dieses Phänomen tritt in besonderer Weise bei Geräten mit einem Weitbereichseingang auf, d. h. bei Geräten, die für einen großen Versorgungsspannungsbereich konzipiert sind, z. B. beschrieben in DE4408009A1 (ABB Management AG) 01.06.1995.

Die Speicherkapazität eines geräteinternen Energiespeichers ist bei diesen Geräten so groß bemessen, dass der Betrieb des Gerätes im Falle eines vorübergehenden Spannungseinbruchs auch bei der niedrigsten erlaubten Versorgungsspannung noch sicherstellt ist. Entsprechend lange dauert es, bis sich der Energiespeicher bis auf ein bestimmtes Niveau entladen hat und eine interne Elektronik des Gerätes das Abschalten des Gerätes erkennt.

Eine lange Verzögerung zwischen einer absichtlichen Geräteabschaltung durch Abschalten der Versorgungsspannung und einer entsprechenden geräteinternen Reaktion kann zu ungewollten oder sogar gefährlichen Zuständen führen.

Der Erfindung liegt daher die Aufgabe zugrunde, die Erkennung einer Geräteabschaltung zu beschleunigen.

Die Aufgabe wird durch eine Schaltungsanordnung gemäß Anspruch 1 gelöst. Die Aufgabe wird ebenfalls gelöst durch ein Gerät gemäß Anspruch 8. Und die Aufgabe wird gelöst durch ein Verfahren gemäß Anspruch 12.

Die erfindungsgemäße Schaltungsanordnung dient zur Erkennung einer Versorgungsspannung für ein Gerät, dessen Versorgungsspannung einen Energiespeicher des Geräts lädt und eine durch den Energiespeicher gepufferte Eingangsgröße einer Steuereinheit des Geräts ist, welche in Abhängigkeit von der Höhe der Versorgungsspannung einen Aktor des Geräts steuert. Dabei weist die Schaltungsanordnung einen Spannungseingang auf, an dem die Versorgungsspannung des Geräts anlegbar ist. Die Schaltungsanordnung weist außerdem ein Integrierglied auf, das dazu geeignet ist, aus der am Spannungseingang anliegenden Spannung durch Integration eine integrierte Spannung zu erzeugen. Das Integrierglied ist ein Integrierer bzw. ein Integrator, d. h. eine Schaltung, die eine zugeführte Spannung integriert. Das Integrierglied kann dabei als ein parallel geschalteter Kondensator oder als ein Siebglied ausgebildet sein. Die Schaltungsanordnung weist einen Signalprozessor auf, der dazu geeignet ist, in Abhängigkeit von der integrierten Spannung ein Ausgangssignal zu erzeugen; der Signalprozessor kann z. B. durch einen Transistor ausgebildet sein, der durch die integrierte Spannung gesteuert wird. Das Ausgangssignal weist einen von zwei möglichen Pegeln auf, je nachdem, ob die Versorgungsspannung einen vorgegebenen Schwellwert überschreitet oder nicht. Der vorgegebene Schwellwert ist vorzugsweise in dem Signalprozessor festgelegt, kann z. B. als eine Schwellspannung eines Transistors definiert sein. Und die Schaltungsanordnung weist einen Signalausgang auf, an dem das Ausgangssignal abgegriffen werden kann. Die Schaltungsanordnung bildet eine elektronische Baugruppe, die auf einer Leiterplatte (engl.: Printed Circuit Board = PCB) angeordnet sein kann.

Die Schaltungsanordnung kann als ein Modul ausgebildet sein, welches einer bestehenden Schaltung, z. B. eines elektrischen Gerätes, insbesondere eines Schaltgeräts wie eines Relais, hinzugefügt werden kann. Die Schaltungsanordnung kann alternativ in den Schaltkreis eines Geräts integriert sein; in diesem Fall ist der Spannungseingang einfach durch Spannungsleitungen gebildet, über welche die Versorgungsspannung eines Gerätes zu den hinter dem Spannungseingang angeordneten Bauelementen der Schaltungsanordnung, insbesondere zu dem Integrierglied, geleitet wird.

Das erfindungsgemäße Gerät weist eine erfindungsgemäße Schaltungsanordnung auf, außerdem Eingangskontakte, an denen eine Versorgungsspannung anlegbar ist. Das Gerät weist auch einen Energiespeicher zum Speichern von elektrischer Energie aus der Versorgungsspannung bzw. einer daraus erzeugten Spannung auf. Das Gerät weist außerdem einen Aktor auf sowie eine Steuereinheit, die dazu ausgebildet ist, den Aktor in Abhängigkeit von einer Höhe der durch den Energiespeicher gepufferten Versorgungsspannung bzw. einer daraus erzeugten Spannung und in Abhängigkeit von dem Ausgangssignal der Schaltungsanordnung anzusteuern. Das Gerät weist außerdem eine elektrische Verbindung auf, die einen elektrischen Kontakt zwischen den Eingangskontakten und dem Spannungseingang der Schaltungsanordnung herstellt. Und das Gerät weist eine Signalverbindung auf, die eine Signalübertragung von dem Signalausgang der Schaltungsanordnung zu der Steuereinheit ermöglicht.

Das erfindungsgemäße Verfahren dient zur Erkennung, ob eine an Eingangskontakten eines Geräts anliegende Versorgungsspannung einen vorgegebenen Schwellwert überschreitet. Dabei lädt die Versorgungsspannung auf einem ersten Leitungspfad einen geräteinternen Energiespeicher. Die Versorgungsspannung bildet außerdem eine durch den besagten Energiespeicher gepufferte Eingangsgröße einer Steuereinheit des Geräts, welche in Abhängigkeit von einer Höhe der Eingangsgröße einen Aktor des Geräts steuert. Auf Basis der an den Eingangskontakten des Geräts anliegenden Versorgungsspannung wird auf einem parallel zum ersten Leitungspfad verlaufenden zweiten Leitungspfad unter Umgehung des Energiespeichers ein Ausgangssignal erzeugt, welches anzeigt, ob die an den Eingangskontakten anliegende Versorgungsspannung einen vorgegebenen Schwellwert überschreitet oder nicht. Das erzeugte Ausgangssignal wird der Steuereinheit zugeführt, welche in Abhängigkeit von dem Ausgangssignal den Aktor ansteuert.

Das Gerät weist eine elektrische Schaltung auf, umfassend den ersten Leitungspfad und den zweiten Leitungspfad. Dabei sind der erste Leitungspfad und der zweite Leitungspfad bezogen auf den auf der Versorgungsspannung basierenden Energie- und Signalfluss von den Eingangskontakten des Gerätes zu der Steuereinheit parallel zueinander angeordnet.

Der Erfindung liegt die Erkenntnis zugrunde, dass durch den geräteinternen Energiespeicher die Ansteuerung des Aktors verzögert wird, weil der Energiespeicher die geräteinterne, an der Steuereinheit anliegende Arbeitsspannung puffert und die Steuereinheit somit ein Abfallen der an den Eingangskontakten anliegenden Versorgungsspannung erst verzögert erkennt. Soll ein Abfallen der an den Eingangskontakten anliegenden Versorgungsspannung schneller erkannt werden, muss der Leitungspfad, in dem der Energiespeicher die Spannung puffert, umgangen werden.

Um die durch den Energiespeicher verursachte Verzögerung einer geräteinternen Reaktion auf ein Abfallen der an den Eingangskontakten anliegenden Versorgungsspannung zu verkürzen, wurde die erfindungsgemäße Schaltungsanordnung zur Spannungserkennung entwickelt. Mit dieser Schaltungsanordnung zur Spannungserkennung wird das Abschalten bzw. das Abfallen einer Versorgungsspannung sehr schnell erkannt, wodurch das Gerät in kürzester Zeit darauf reagieren kann. In einem Schaltgerät zur Betätigung eines Relais kann mit dieser Schaltungsanordnung ein schnelles Abschalten des intern angesteuerten Relais eingeleitet werden.

Vorteilhafte Ausgestaltungen und Weiterbildungen der Erfindung sind in den abhängigen Ansprüchen angegeben. Dabei kann das erfindungsgemäße Verfahren auch entsprechend den abhängigen Vorrichtungsansprüchen weitergebildet sein, und umgekehrt.

Gemäß einer bevorzugten Ausgestaltung der Erfindung weist die Schaltungsanordnung einen ersten Gleichrichter auf, der dazu geeignet ist, durch Gleichrichtung der an dem Spannungseingang anliegenden Versorgungsspannung eine erste gleichgerichtete Spannung zu erzeugen. Diese erste gleichgerichtete Spannung wird anstatt der Versorgungsspannung dem Integrierglied zur Integration zugeführt. Falls eine Gleichspannung als Versorgungsspannung anliegt, ist kein Gleichrichter nötig; falls aber eine Wechselspannung als Versorgungsspannung anliegt, muss eine Gleichrichtung erfolgen, falls der Integrator als ein Kondensator ausgebildet ist - andernfalls würde der Kondensator während einer positiven Halbwelle geladen und während einer darauffolgenden negativen Halbwelle wieder entladen.

Gemäß einer bevorzugten Ausgestaltung der Erfindung wird der erste Gleichrichter der Schaltungsanordnung durch mindestens eine Diode gebildet. Der Gleichrichter kann durch eine Diode gebildet sein, sodass bei einer Wechselspannung immer nur jede zweite Halbwelle zur Ladung eines Kondensators verwendet wird. Wird der Gleichrichter durch zwei Dioden gebildet, jeweils eine Diode je Leitung eines Leitungspaars, so wird jede Halbwelle zur Ladung eines Kondensators verwendet. Es sind auch Gleichrichter mit mehr als zwei Dioden einsetzbar, z. B. Brückengleichrichter, welche vier Dioden verwenden.

Gemäß einer bevorzugten Ausgestaltung der Erfindung weist die Schaltungsanordnung eine vor dem Integrierglied angeordnete Begrenzungseinheit auf, die dazu geeignet ist, die dem Integrierglied zur Integration zuzuführende Spannung zu begrenzen, z. B. durch eine Begrenzung der Spannung auf eine vorgegebene maximale Amplitude. Diese Begrenzungseinheit kann z. B. mit einer Zenerdiode ausgebildet sein. Die Begrenzungseinheit ist insbesondere bei Weitbereichsgeräten von Vorteil, d. h. wenn an den Spannungseingang Versorgungsspannungen aus einem sehr großen Spannungsbereich, z. B. zwischen 24 VAC und 240 VAC, angelegt werden können. Durch die Begrenzungseinheit kann die integrierte Spannung auch bei sehr unterschiedlichen Versorgungsspannungen, z. B. bei 24 VAC und bei 240 VAC, in einem relativ engen Pegelbereich gehalten werden. Auf diese Weise erfolgt nach einem Abfallen der Versorgungsspannung, z. B. hervorgerufen durch ein gewolltes Abschalten der Versorgungsspannung von den Eingangskontakten des Gerätes, die Erzeugung des entsprechenden Ausgangssignals, durch welches der Steuereinheit dieses Abfallen anzeigt werden soll, auch bei sehr unterschiedlich großen Versorgungsspannungen nach einer ähnlich langen Zeitspanne. Durch die Begrenzung wird eine Unabhängigkeit der nachfolgenden Schaltungsteile von der Größe der Eingangsspannung erreicht.

Gemäß einer bevorzugten Ausgestaltung der Erfindung kodieren die zwei möglichen Pegel eine logische Null und eine logische Eins, d. h. das Ausgangssignal ist ein digitales Signal (1 oder 0). Ein Vorteil dabei ist, dass die Steuereinheit ein eindeutiges Signal erhält, welches keiner Nachauswertung durch die Steuereinheit bedarf. Außerdem wird das Ausgangssignal gegen Übertragungsfehler sicherer.

Gemäß einer bevorzugten Ausgestaltung der Erfindung ist der Signalprozessor als ein Transistor oder ein Operationsverstärker ausgebildet ist, der die integrierte Spannung als ein Steuersignal dazu verwendet, das Ausgangssignal zu erzeugen. Ein Vorteil dabei ist, dass diese Ausgestaltung des Signalprozessor relativ einfach ist.

Gemäß einer bevorzugten Ausgestaltung der Erfindung weist die Schaltungsanordnung einen mit dem Signalprozessor elektrisch verbundenen zweiten Spannungseingang auf, an dem eine Spannung angelegt werden kann, die dem Signalprozessor zur Erzeugung des Ausgangssignals zur Verfügung stehen soll. Ein Vorteil dabei ist, dass die möglichen Pegel des Ausgangssignals einfach vorgegeben werden kann.

Gemäß einer bevorzugten Ausgestaltung der Erfindung weist das Gerät einen zweiten Gleichrichter zum Gleichrichten der an den Eingangskontakten anliegenden Versorgungsspannung auf. Diese erste gleichgerichtete Spannung wird anstatt der Versorgungsspannung dem Energiespeicher zugeführt. Falls eine Gleichspannung als Versorgungsspannung anliegt, ist kein Gleichrichter nötig; falls aber eine Wechselspannung als Versorgungsspannung anliegt, muss eine Gleichrichtung erfolgen - andernfalls würde der Energiespeicher während einer positiven Halbwelle geladen und während einer darauffolgenden negativen Halbwelle wieder entladen.

Gemäß einer bevorzugten Ausgestaltung der Erfindung ist der Aktor des Geräts ein Relais. Dadurch kann das Gerät elektrische Schaltfunktionen erfüllen.

Gemäß einer bevorzugten Ausgestaltung der Erfindung weist das Gerät einen vor der Steuereinheit angeordneten Spannungsregler auf sowie eine elektrische Verbindung, über die eine als Ausgangssignal des Spannungsreglers erzeugte geregelte Spannung dem zweiten Spannungseingang zuführbar ist. Das Attribut "vor der Steuereinheit" ist bezogen auf den auf der Versorgungsspannung basierenden Energie- und Signalfluss von den Eingangskontakten des Gerätes zu der Steuereinheit. Von Vorteil ist hierbei, dass der Spannungsregler das der Steuereinheit zugeführte Spannungssignal der geregelten Spannung, welches auf der an den Eingangskontakten anliegenden Versorgungsspannung basiert, auf ein passendes Niveau einregeln kann. Außerdem kann das Spannungssignal der geregelten Spannung vorteilhaft zur Erzeugung des Ausgangssignals verwendet werden, z. B. zur Erzeugung eines Hochpegel-Ausgangssignals.

Gemäß einer bevorzugten Ausgestaltung der Erfindung wird zunächst die Versorgungsspannung auf dem zweiten Leitungspfad zu einem Integrierglied geführt; das Integrierglied kann dabei als ein parallel geschalteter Kondensator ausgebildet sein. Dann wird aus der Versorgungsspannung durch Integration mittels des Integrierglieds eine integrierte Spannung erzeugt. Daraufhin wird aus der integrierten Spannung das Ausgangssignal erzeugt. Von Vorteil ist hierbei, dass ein einfaches und kostengünstiges elektronisches Bauteil, nämlich ein Integrierglied, zur Erzeugung des Ausgangssignal verwendet wird.

Gemäß einer bevorzugten Ausgestaltung der Erfindung weist das Ausgangssignal einen von zwei möglichen Pegeln auf, in Abhängigkeit davon, ob die an den Eingangskontakten anliegende Versorgungsspannung den vorgegebenen Schwellwert überschreitet oder nicht. Die zwei möglichen Pegel können zwei verschieden hohe Spannungspegel sein. Die zwei möglichen Pegel können eine logische Null und eine logische Eins kodieren. Das Ausgangssignal wird der Steuereinheit zugeführt, welche in Abhängigkeit von dem Pegel des Ausgangssignals den Aktor ansteuert. Der Vorteil dabei ist, dass die Steuereinheit ein eindeutiges Signal erhält, welches keiner Nachauswertung durch die Steuereinheit bedarf. Außerdem wird das Ausgangssignal gegen Übertragungsfehler sicherer.

Gemäß einer bevorzugten Ausgestaltung der Erfindung wird aus der auf dem zweiten Leitungspfad geführten Versorgungsspannung durch einen ersten Gleichrichter eine erste gleichgerichtete Spannung erzeugt, aus welcher die integrierte Spannung erzeugt wird. Falls eine Gleichspannung als Versorgungsspannung anliegt, ist kein Gleichrichter nötig; falls aber eine Wechselspannung als Versorgungsspannung anliegt, muss eine Gleichrichtung erfolgen, falls der Integrator als ein Kondensator ausgebildet ist - andernfalls würde der Kondensator während einer positiven Halbwelle geladen und während einer darauffolgenden negativen Halbwelle wieder entladen.

Die oben beschriebenen Eigenschaften, Merkmale und Vorteile dieser Erfindung sowie die Art und Weise, wie diese erreicht werden, werden klarer und deutlicher verständlich durch die folgende Beschreibung der Zeichnungen. Hierbei zeigen in schematischer und nicht maßstabsgetreuer Darstellung:
- FIG 1: eine erste Ausgestaltung einer Schaltungsanordnung;
- FIG 2: eine weitere Ausgestaltung einer Schaltungsanordnung;
- FIG 3: ein Schaltgerät;
- FIG 4: eine Übersicht zeitlicher Spannungs- und Signalverläufe, die in dem Gerät gemäß FIG 3 auftreten; und
- FIG 5: ein Ablaufdiagramm.

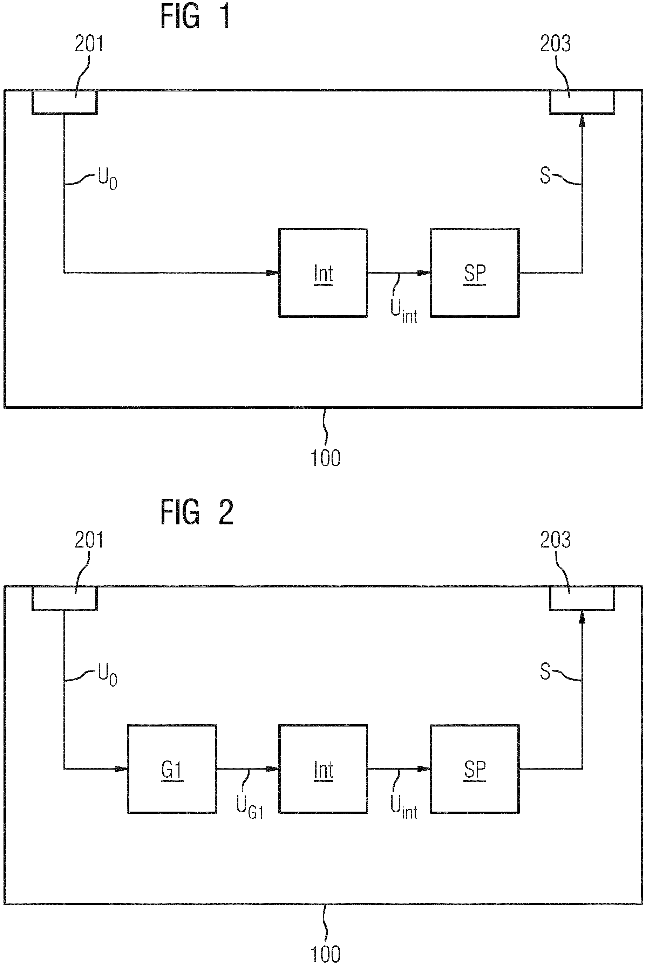

FIG 1 zeigt eine schematische Darstellung einer ersten Ausgestaltung einer Schaltungsanordnung 100 zur Spannungserkennung. Die Schaltungsanordnung 100 bildet eine elektronische Baugruppe, die auf einer Leiterplatte (PCB) angeordnet ist. Die Schaltungsanordnung 100 ist als ein Modul ausgebildet, welches an eine bestehende Schaltung, z. B. eines elektrischen Gerätes, insbesondere eines Schaltgeräts wie eines Relais, hinzugefügt werden kann. Die Schaltungsanordnung 100 weist einen Spannungseingang 201, ein Integrierglied Int, einen Signalprozessor SP sowie einen Signalausgang 203 auf.

Der Spannungseingang 201 ist eine Vorrichtung zum Anlegen einer elektrischen Spannung, z. B. bestehend aus zwei elektrischen Anschlussstellen (z.B. Klemmpunkte oder Lötpunkte auf einer Leiterplatte). Der Spannungseingang 201 kann mit elektrischen Leitungen verbunden werden, durch die eine Versorgungsspannung U₀ eines Gerätes an den Spannungseingang 201 angelegt werden kann.

Der Spannungseingang 201 ist so mit dem Integrierglied Int elektrisch verbunden, dass eine am Spannungseingang 201 anliegende Versorgungsspannung U₀ dem Integrierglied Int zugeführt wird. Das Integrierglied Int, welches als ein parallel geschalteter Kondensator ausgebildet sein kann, erzeugt durch Integration der Versorgungsspannung U₀ eine integrierte Spannung Uᵢₙₜ .

Das Integrierglied Int ist so mit dem Signalprozessor SP elektrisch verbunden, dass die integrierte Spannung Uᵢₙₜ dem Signalprozessor SP zugeführt wird. Der Signalprozessor SP erzeugt in Abhängigkeit von der integrierten Spannung Uᵢₙₜ ein Ausgangssignal S; dabei kodiert das Ausgangssignal S einen von zwei möglichen Zuständen, je nachdem, ob an dem Spannungseingang 201 eine Versorgungsspannung U₀ anliegt oder nicht.

Der Signalprozessor SP ist so mit dem Signalausgang 203 elektrisch verbunden, dass das Ausgangssignal S dem Signalausgang 203 zugeführt wird und dort abgegriffen werden kann. Der Signalausgang 203 ist eine Vorrichtung zum Abgreifen eines elektrischen Signals, z. B. bestehend aus zwei elektrischen Anschlussstellen (z.B. Klemmpunkte oder Lötpunkte auf einer Leiterplatte). Der Signalausgang 203 kann mit elektrischen Leitungen verbunden werden, durch die das Ausgangssignal S einem anderen Bauelement zugeführt werden kann.

Die in FIG 1 dargestellte Schaltungsanordnung 100 ist insbesondere dann vorteilhaft anwendbar, wenn die Versorgungsspannung U₀ eine Gleichspannung ist, für die keine Gleichrichtung nötig ist.

FIG 2 zeigt eine schematische Darstellung einer weiteren Ausgestaltung einer Schaltungsanordnung 100 zur Spannungserkennung. Die Schaltungsanordnung 100 bildet eine elektronische Baugruppe, die auf einer Leiterplatte (PCB) angeordnet ist. Die Schaltungsanordnung 100 ist als ein Modul ausgebildet, welches an eine bestehende Schaltung, z. B. eines elektrischen Gerätes, insbesondere eines Schaltgeräts wie eines Relais, hinzugefügt werden kann. Die Schaltungsanordnung 100 weist einen Spannungseingang 201, einen ersten Gleichrichter G1, ein Integrierglied Int, einen Signalprozessor SP sowie einen Signalausgang 203 auf.

Der Spannungseingang 201 ist eine Vorrichtung zum Anlegen einer elektrischen Spannung, z. B. bestehend aus zwei elektrischen Anschlussstellen (z.B. Klemmpunkte oder Lötpunkte auf einer Leiterplatte). Der Spannungseingang 201 kann mit elektrischen Leitungen verbunden werden, durch die eine Versorgungsspannung U₀ eines Gerätes an den Spannungseingang 201 angelegt werden kann.

Der Spannungseingang 201 ist so mit dem ersten Gleichrichter G1 elektrisch verbunden, dass eine am Spannungseingang 201 anliegende Versorgungsspannung U₀ dem ersten Gleichrichter G1 zugeführt wird. Der erste Gleichrichter G1 führt eine Gleichrichtung der Versorgungsspannung U₀ durch und erzeugt dadurch eine erste gleichgerichtete Spannung U_{G1}. Eine Gleichspannung bleibt durch den ersten Gleichrichter G1 unverändert; aus einer Wechselspannung dagegen erzeugt der erste Gleichrichter G1 eine pulsierende Gleichspannung U_{G1}.

Der erste Gleichrichter G1 ist so mit dem Integrierglied Int elektrisch verbunden, dass die erste gleichgerichtete Spannung U_{G1} dem Integrierglied Int zugeführt wird. Das Integrierglied Int, welches als ein parallel geschalteter Kondensator ausgebildet sein kann, erzeugt durch Integration der ersten gleichgerichteten Spannung U_{G1} eine integrierte Spannung Uᵢₙₜ .

Das Integrierglied Int ist so mit dem Signalprozessor SP elektrisch verbunden, dass die integrierte Spannung Uᵢₙₜ dem Signalprozessor SP zugeführt wird. Der Signalprozessor SP erzeugt in Abhängigkeit von der integrierten Spannung Uᵢₙₜ ein Ausgangssignal S; dabei kodiert das Ausgangssignal S einen von zwei möglichen Zuständen, je nachdem, ob an dem Spannungseingang 201 eine Versorgungsspannung U₀ anliegt oder nicht.

Der Signalprozessor SP ist so mit dem Signalausgang 203 elektrisch verbunden, dass das Ausgangssignal S dem Signalausgang 203 zugeführt wird und dort abgegriffen werden kann. Der Signalausgang 203 ist eine Vorrichtung zum Abgreifen eines elektrischen Signals, z. B. bestehend aus zwei elektrischen Anschlussstellen (z.B. Klemmpunkte oder Lötpunkte auf einer Leiterplatte). Der Signalausgang 203 kann mit elektrischen Leitungen verbunden werden, durch die das Ausgangssignal S einem anderen Bauelement zugeführt werden kann.

Die in FIG 2 dargestellte Schaltungsanordnung 100 ist insbesondere dann vorteilhaft anwendbar, wenn die Versorgungsspannung U₀ eine Wechselspannung ist, für die eine Gleichrichtung nötig ist.

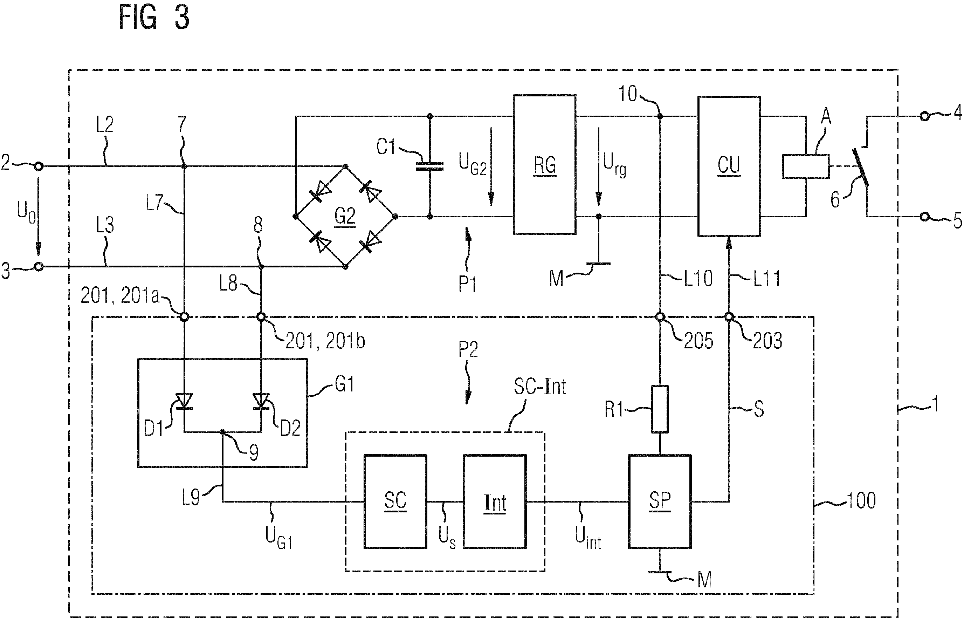

FIG 3 zeigt eine schematische Darstellung eines Geräts 1, welches eine Schaltungsanordnung 100 aufweist. Das Gerät 1 ist ein Schaltgerät wie z. B. ein Relais.

Das Gerät 1 weist eine als ein zweiter Leitungspfad P2 des Geräts 1 fungierende Schaltungsanordnung 100 auf, welche einen Spannungseingang 201, einen ersten Gleichrichter G1, eine Begrenzungs- und Integrier-Schaltung SC-Int, einen Signalprozessor SP, einen Widerstand R1 sowie einen Signalausgang 203 aufweist. Dabei weist die Begrenzungs- und Integrier-Schaltung SC-Int eine Begrenzungs-Schaltung SC und ein Integrierglied Int auf.

Das Gerät 1 weist außer der Schaltungsanordnung 100 noch Eingangskontakte 2, 3 und, in einem ersten Leitungspfad P1 des Geräts 1, einen zweiten Gleichrichter G2, einen Pufferkondensator C1, einen Spannungsregler RG und eine Steuer-Einheit CU auf. Das Gerät 1 weist außerdem einen Aktor A auf, einen vom Aktor A betätigbaren Schalter 6 und durch den Schalter 6 miteinander verbindbare Ausgangskontakte 4, 5.

An die Eingangskontakte 2, 3, z. B. Anschlussklemmen, ist eine Versorgungsspannung U₀ des Geräts 1 anlegbar. Der zweite Gleichrichter G2 ist als ein Brückengleichrichter ausgebildet, der zum Gleichrichten der an den Eingangskontakten 2, 3 anliegenden Versorgungsspannung U₀ dient. Zum Anlegen der Versorgungsspannung U₀ an den zweiten Gleichrichter G2 sind die Eingangskontakte 2, 3 durch elektrische Verbindungen L2, L3 mit dem zweiten Gleichrichter G2 verbunden. Der zweite Gleichrichter G2 erzeugt aus der Versorgungsspannung U₀ des Geräts 1 eine zweite gleichgerichtete Spannung U_{G2}.

Das Gerät 1 weist elektrische Verbindungen auf, mit denen die Ausgangsspannung des zweiten Gleichrichters G2, d. h. die zweite gleichgerichtete Spannung U_{G2}, als eine Eingangsspannung an den Spannungsregler RG angelegt werden kann.

Zwischen dem Gleichrichter G2 und dem Spannungsregler RG ist in dem ersten Leitungspfad P1 der parallel geschaltete Pufferkondensator C1 angeordnet, der sich unter der Wirkung der zweiten gleichgerichteten Spannung U_{G2} mit elektrischer Energie lädt und als Energiespeicher für eine unterbrechungsfreie Energieversorgung der Steuer-Einheit CU dient.

Das Gerät 1 weist elektrische Verbindungen auf, mit denen die Ausgangsspannung U_{rg} des Spannungsreglers RG als eine Eingangsspannung an die Steuereinheit CU angelegt werden kann. Der Aktor A ist als ein Relais ausgebildet; er kann von der Steuereinheit CU angesteuert werden, um einen Schalter 6 zu betätigen, der eine elektrische Verbindung zwischen zwei Ausgangskontakten 4, 5 des Geräts herstellt bzw. unterbricht. Mittels des Relais A kann ein externer Stromkreis, der durch Anschließen an die Ausgangskontakte 4, 5 des Geräts 1 über den Schalter 6 geführt ist, geschlossen bzw. geöffnet und der Betrieb einer elektrischen Last, z. B. eines Elektromotors, gesteuert werden.

Das Gerät weist elektrische Verbindungen L7, L8 auf, die die an den elektrischen Verbindungen L2, L3 angeordneten Abgreifpunkte 7, 8, an denen die Versorgungsspannung U₀ des Geräts 1 abgegriffen wird, mit dem Spannungseingang 201 der Schaltungsanordnung 100 verbinden; dazu weist der Spannungseingang 201 zwei Kontaktpunkte 201a und 201b auf. Somit wird ein elektrischer Kontakt zwischen den Eingangskontakten 2, 3 des Gerätes 1 und dem Spannungseingang 201 der Schaltungsanordnung 100 herstellt.

Der erste Gleichrichter G1, der in der Schaltungsanordnung 100 angeordnet ist, weist zwei Dioden D1 und D2 auf, die zur Umwandlung von Wechselspannung in Gleichspannung dienen. Die über den Verbindungspunkt 9 und eine elektrische Verbindung L9 aus dem ersten Gleichrichter G1 austretende erste gleichgerichtete Spannung U_{G1} wird der Begrenzungs- und Integrier-Schaltung SC-Int zugeführt, die eine Begrenzungs-Schaltung SC zum Erzeugen einer begrenzten Spannung U_{S} aus der ersten gleichgerichteten Spannung U_{G1} sowie ein Integrierglied Int zum Erzeugen einer integrierten Spannung Uᵢₙₜ durch Integration der begrenzten Spannung U_{S} aufweist.

Die Ausgangsspannung der Begrenzungs- und Integrier-Schaltung SC-Int, d. h. die integrierte Spannung Uᵢₙₜ, wird dem Signalprozessor SP zugeführt, der in Abhängigkeit von der integrierten Spannung Uᵢₙₜ ein Ausgangssignal S erzeugt, wobei das Ausgangssignal S einen von zwei möglichen Zuständen, z. B. Null (0) und Eins (1), kodiert, je nachdem, ob an dem Spannungseingang 201, und also an den Eingangskontakten 2, 3 des Gerätes 1, eine Versorgungsspannung U₀ anliegt oder nicht.

Über einen weiteren Spannungseingang 205 der Schaltungsanordnung 100 wird dem Signalprozessor SP die geregelte Spannung U_{rg} zugeführt. Dazu wird die geregelte Spannung U_{rg} an einem Abgreifpunkt 10 zwischen dem Spannungsregler RG und der Steuereinheit CU abgegriffen und über eine elektrische Verbindung L10 und einen Widerstand R1, einen sogenannten Pull-up-Widerstand, an den Signalprozessor SP angelegt. Der Bezugspunkt der geregelten Spannung U_{rg} ist dabei ein mit Masse M bezeichnetes Potential.

Der Signalprozessor SP kann ein Halbleiterschalter, z. B. ein Transistor, sein, der durch die integrierte Spannung Uᵢₙₜ gesteuert wird: Falls die integrierte Spannung Uᵢₙₜ so groß ist, dass der Transistor leitend geschaltet wird, kann das Ausgangssignal durch eine erste Spannung, z. B. ein Massepotential, gebildet werden (digitales Signal 0). Im anderen Fall, d. h. falls die integrierte Spannung Uᵢₙₜ zu klein ist, dass der Transistor leitend geschaltet wird, kann das Ausgangssignal durch eine zweite Spannung, z. B. die geregelte Spannung U_{rg}, gebildet werden (digitales Signal 1).

Über eine Signalverbindung L11 kann das Ausgangssignal S des Signalprozessors SP von einem Signalausgang 203 der Schaltungsanordnung 100 zu der Steuereinheit CU übertragen werden. Die Steuereinheit CU verwendet das Ausgangssignal S, um zu entscheiden, ob der Aktor angesteuert werden soll. Sobald der Steuereinheit CU über den zweiten Leitungspfad P2 mittels des Ausgangssignals S signalisiert wird, dass die Versorgungsspannung U₀ an den Eingangskontakten 2, 3 abgeschaltet wurde, kann die Steuereinheit CU in Bezug auf eine Ansteuerung des Aktors A die notwendige Aktion vornehmen; durch die Signalisierung über den zweiten Leitungspfad P2 unter Umgehung des Pufferkondensators C1 kann die Steuereinheit CU schneller auf eine veränderte Versorgungsspannung U₀ (Einschalten oder Abschalten) reagieren, durch Ansteuern des Aktors A, als wenn die Steuereinheit CU auf eine Änderung der über den ersten Leitungspfad P1 an der Steuereinheit CU anliegenden geregelten Spannung U_{rg} warten würde, die aufgrund des Entladeverhaltens des Pufferkondensators C1 ja erst verzögert eintritt.

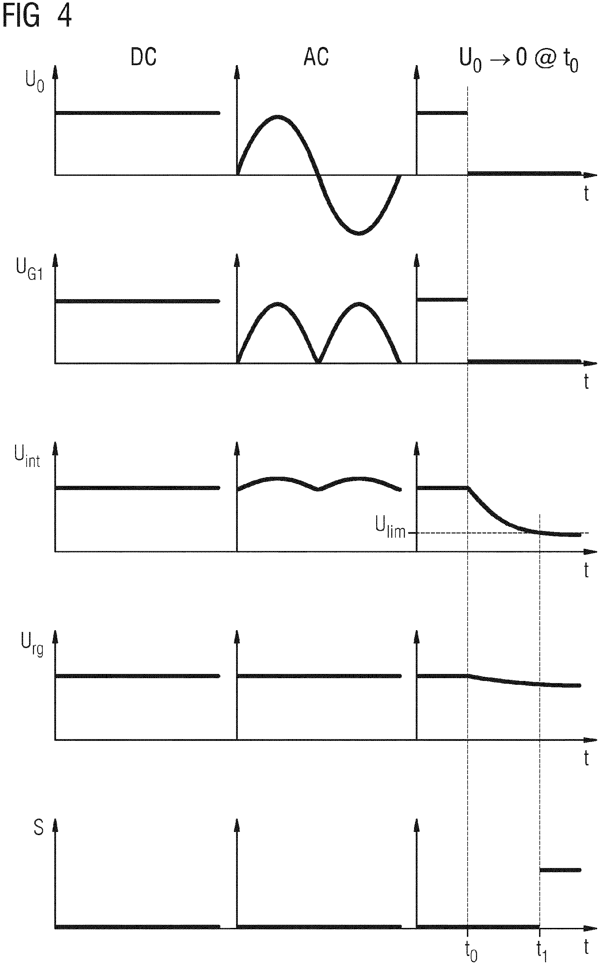

FIG 4 ist eine Übersicht zeitlicher Spannungs- und Signalverläufe, die in dem Gerät gemäß FIG 2 auftreten, falls der Signalprozessor SP als ein Si-Transistor ausgebildet ist, der unterhalb einer Sperrspannung Uₗᵢₘ von ca. 0,7 Volt sperrt. Betrachtet werden die zeitlichen Verläufe von erster gleichgerichteter Spannung U_{G1}, integrierter Spannung Uᵢₙₜ, geregelter Spannung U_{rg} sowie Ausgangssignal S jeweils für drei verschiedene Situationen: in der linken Spalte liegt als Versorgungsspannung U₀ eine Gleichspannung (DC) an, in der mittleren Spalte liegt als Versorgungsspannung U₀ eine Wechselspannung (AC) an und in der rechten Spalte ist das zeitliche Verhalten um den Zeitpunkt t₀ skizziert, zu dem die Versorgungsspannung U₀ abgeschaltet wird (U₀ -> 0 @ t₀).

Falls die Versorgungsspannung U₀ eine Gleichspannung ist (linke Spalte "DC"), bleibt die erste gleichgerichtete Spannung U_{G1} nach dem ersten Gleichrichter G1 eine Gleichspannung. Die integrierte Spannung Uᵢₙₜ nach dem Integrierglied Int ist ebenfalls eine Gleichspannung. Die geregelte Spannung U_{rg} nach dem Spannungsregler RG ist analog zur ersten gleichgerichteten Spannung U_{G1} eine Gleichspannung. Das aus den Werten von integrierter Spannung Uᵢₙₜ und Massepotential im Signalprozessor SP erzeugte Ausgangssignal S ist dann eine Nullspannung, entsprechend einer logischen Null.

Das gleiche Ausgangssignal S wie bei einer Gleichspannung ergibt sich mit einer Wechselspannung: Falls die Versorgungsspannung U₀ eine sinusförmige Wechselspannung ist (mittlere Spalte "AC"), ist die erste gleichgerichtete Spannung U_{G1} nach dem ersten Gleichrichter G1 eine pulsierende Gleichspannung. Die integrierte Spannung Uᵢₙₜ nach dem Integrierglied Int ist eine geglättete pulsierende Gleichspannung. Die geregelte Spannung U_{rg} nach dem Spannungsregler RG ist, aufgrund der Spannungsregelung durch den Spannungsregler RG, eine Gleichspannung. Das aus den Werten von integrierter Spannung Uᵢₙₜ und Massepotential im Signalprozessor SP erzeugte Ausgangssignal S ist dann eine logische Null.

Sobald aber die Versorgungsspannung U₀, sei es DC oder AC, am Spannungseingang 201 des Geräts 1 zu einem Abschaltzeitpunkt t₀ abgeschaltet wird (rechte Spalte "U₀ -> 0 @ t₀"), ergibt sich ein anderes Ausgangssignal S als bei DC und AC: die erste gleichgerichtete Spannung U_{G1} nach dem ersten Gleichrichter G1 wechselt im Abschaltzeitpunkt t₀, da im zweiten Leitungspfad P2 keine Pufferung durch einen Stützkondensator stattfindet, zu Null. Die integrierte Spannung Uᵢₙₜ, die durch das Integrierglied Int gebildet wird, sinkt ab dem Abschaltzeitpunkt t₀ exponentiell. Die geregelte Spannung U_{rg}, die durch den Spannungsregler RG gebildet wird, sinkt ab dem Abschaltzeitpunkt t₀ exponentiell, aber mit einer wesentlich größeren Halbwertszeit als die integrierte Spannung Uᵢₙₜ, da im ersten Leitungspfad P1 eine wesentliche Pufferung durch den Pufferkondensator C1 stattfindet; durch die langsame Entladung des Pufferkondensator C1 fällt die geregelte Spannung U_{rg} im Vergleich zu der integrierten Spannung Uᵢₙₜ langsamer ab. Sobald die integrierte Spannung Uᵢₙₜ zum Zeitpunkt t1 auf die Sperrspannung Uₗᵢₘ von ca. 0,7 Volt abgesunken ist, sperrt der Transistor und das Ausgangssignal S wechselt von Null auf eine logische Eins, einem Signalwert, welcher auf Basis der Werte von integrierter Spannung Uᵢₙₜ und geregelter Spannung U_{rg} erzeugt wird.

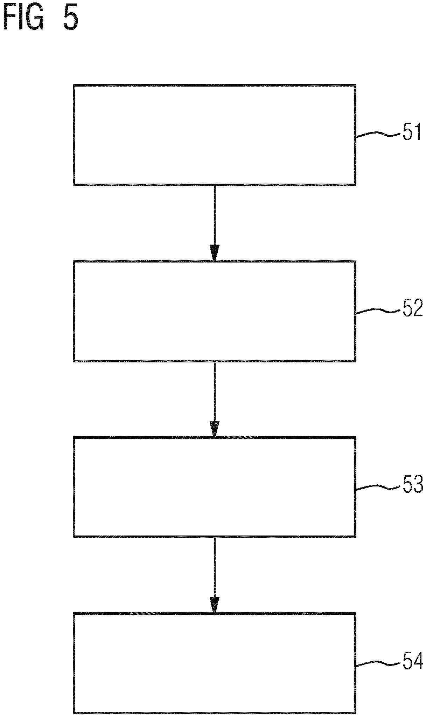

FIG 5 zeigt ein Ablaufdiagramm für ein Ausführungsbeispiel des erfindungsgemäßen Verfahrens. Das Verfahren dient einer Erkennung, ob eine Versorgungsspannung an einem Spannungseingang anliegt. Das Verfahren weist einen ersten Schritt 51 auf, in dem die Versorgungsspannung U₀ auf dem zweiten Leitungspfad P2 zu einem Integrierglied Int geführt wird. Das Verfahren weist einen zweiten Schritt 52 auf, in dem aus der Versorgungsspannung U₀ durch Integration mittels des Integrierglieds Int eine integrierte Spannung Uᵢₙₜ erzeugt wird. Das Verfahren weist einen dritten Schritt 53 auf, in dem aus der integrierten Spannung Uᵢₙₜ in einem Signalprozessor SP ein Ausgangssignal S erzeugt wird, wobei das Ausgangssignal S unterschiedlich ist, in Abhängigkeit davon, ob am Weitbereichseingang eine Versorgungsspannung U₀ anliegt oder nicht. Und das Verfahren weist einen vierten Schritt 54 auf, in dem das Ausgangssignal S der Steuereinheit CU zugeführt wird, welche in Abhängigkeit von dem Ausgangssignal S den Aktor A ansteuert.

## Patentansprüche

1. Schaltungsanordnung (100) zur Erkennung einer Versorgungsspannung (U₀) für ein Gerät (1), dessen Versorgungsspannung (U₀) einen Energiespeicher (C1) des Geräts (1) lädt und eine durch den Energiespeicher (C1) gepufferte Eingangsgröße einer Steuereinheit (CU) des Geräts (1) ist, welche in Abhängigkeit von der Höhe der Versorgungsspannung (U₀) einen Aktor (A) des Geräts (1) steuert,
wobei die Schaltungsanordnung (100) aufweist:
- einen Spannungseingang (201), an dem die Versorgungsspannung (U₀) des Geräts (1) anlegbar ist,
- ein Integrierglied (Int), das dazu geeignet ist, aus der am Spannungseingang (201) anliegenden Spannung (U₀) durch Integration eine integrierte Spannung (Uᵢₙₜ) zu erzeugen,
- einen Signalprozessor (SP), der dazu geeignet ist, in Abhängigkeit von der integrierten Spannung (Uᵢₙₜ) ein Ausgangssignal (S) zu erzeugen, welches einen von zwei möglichen Pegeln aufweist, je nachdem, ob die Versorgungsspannung (U₀) einen vorgegebenen Schwellwert überschreitet oder nicht, und
- einen Signalausgang (203), an dem das Ausgangssignal (S) abgegriffen werden kann.

2. Schaltungsanordnung (100) nach Anspruch 1, mit einem ersten Gleichrichter (G1), der dazu geeignet ist, durch Gleichrichtung der an dem Spannungseingang (201) anliegenden Versorgungsspannung (U₀) eine erste gleichgerichtete Spannung (U_{G1}) zu erzeugen, welche anstatt der Versorgungsspannung (U₀) dem Integrierglied (Int) zur Integration zugeführt wird.

3. Schaltungsanordnung (100) nach Anspruch 2, wobei der erste Gleichrichter (G1) durch mindestens eine Diode (D1, D2) gebildet ist.

4. Schaltungsanordnung (100) nach einem der Ansprüche 1 bis 3, mit einer vor dem Integrierglied (Int) angeordneten Begrenzungseinheit (SC), die dazu geeignet ist, die dem Integrierglied (Int) zur Integration zuzuführende Spannung auf einen vorgegebenen Höchstwert (Uₘₐₓ) zu begrenzen.

5. Schaltungsanordnung (100) nach einem der vorhergehenden Ansprüche, wobei die zwei möglichen Pegel eine logische Null und eine logische Eins kodieren.

6. Schaltungsanordnung (100) nach einem der vorhergehenden Ansprüche, wobei der Signalprozessor (SP) als ein Transistor oder ein Operationsverstärker ausgebildet ist, der die integrierte Spannung (Uᵢₙₜ) als ein Steuersignal dazu verwendet, das Ausgangssignal (S) zu erzeugen.

7. Schaltungsanordnung (100) nach einem der vorhergehenden Ansprüche, mit einem mit dem Signalprozessor (SP) elektrisch verbundenen zweiten Spannungseingang (205), an dem eine Spannung (U_{rg}) angelegt werden kann, die dem Signalprozessor (SP) zur Erzeugung des Ausgangssignals (S) zur Verfügung stehen soll.

8. Gerät (1) mit einer Schaltungsanordnung (100) nach einem der Ansprüche 1 bis 7, wobei das Gerät (1) außerdem aufweist:
- Eingangskontakte (2, 3), an denen eine Versorgungsspannung (U₀) anlegbar ist,
- einen Energiespeicher (C1) zum Speichern von elektrischer Energie aus der Versorgungsspannung (U₀) bzw. einer daraus erzeugten Spannung (U_{G2}),
- einen Aktor (A),
- eine Steuereinheit (CU), die dazu ausgebildet ist, den Aktor (A) in Abhängigkeit von einer Höhe der durch den Energiespeicher (C1) gepufferten Versorgungsspannung (U₀) bzw. einer daraus erzeugten Spannung (U_{G2}, U_{rg}) und in Abhängigkeit von dem Ausgangssignal (S) anzusteuern,
- eine elektrische Verbindung (7, 8, L7, L8), die einen elektrischen Kontakt zwischen den Eingangskontakten (2, 3) und dem Spannungseingang (201) der Schaltungsanordnung (100) herstellt, und
- eine Signalverbindung (L11), die eine Signalübertragung von dem Signalausgang (203) der Schaltungsanordnung (100) zu der Steuereinheit (CU) ermöglicht.

9. Gerät (1) nach Anspruch 8, mit einem zweiten Gleichrichter (G2) zum Gleichrichten der an den Eingangsklemmen (2, 3) anliegenden Versorgungsspannung (U₀).

10. Gerät nach einem der Ansprüche 8 oder 9, wobei der Aktor (A) ein Relais ist.

11. Gerät nach einem der Ansprüche 8 bis 10, mit einem vor der Steuereinheit (CU) angeordneten Spannungsregler (RG) und einer elektrischen Verbindung (L10), über die eine als Ausgangssignal des Spannungsreglers (RG) erzeugte geregelte Spannung (U_{rg}) dem zweiten Spannungseingang (205) zuführbar ist.

12. Verfahren zur Erkennung, ob eine an Eingangskontakten (2, 3) eines Geräts (1) anliegende Versorgungsspannung (U₀) einen vorgegebenen Schwellwert überschreitet, wobei die Versorgungsspannung (U₀) auf einem ersten Leitungspfad (P1) einen geräteinternen Energiespeicher (C1) lädt und eine durch den besagten Energiespeicher (C1) gepufferte Eingangsgröße einer Steuereinheit (CU) des Geräts (1) bildet, welche in Abhängigkeit von einer Höhe dieser Eingangsgröße einen Aktor (A) des Geräts (1) steuert, wobei
- auf Basis der an den Eingangskontakten (2, 3) des Geräts (1) anliegenden Versorgungsspannung (U₀) auf einem parallel zum ersten Leitungspfad (P1) verlaufenden zweiten Leitungspfad (P2) unter Umgehung des Energiespeichers (C1) ein Ausgangssignal (S) erzeugt wird (51, 52, 53), welches anzeigt, ob die an den Eingangskontakten (2, 3) anliegende Versorgungsspannung (U₀) einen vorgegebenen Schwellwert überschreitet oder nicht, und
- das Ausgangssignal (S) der Steuereinheit (CU) zugeführt wird (54), welche in Abhängigkeit von dem Ausgangssignal (S) den Aktor (A) ansteuert.

13. Verfahren nach Anspruch 12, wobei
- die Versorgungsspannung (U₀) auf dem zweiten Leitungspfad (P2) zu einem Integrierglied (Int) geführt wird (51),
- aus der Versorgungsspannung (U₀) durch Integration mittels des Integrierglieds (Int) eine integrierte Spannung (Uᵢₙₜ) erzeugt wird (52), und
- aus der integrierten Spannung (Uᵢₙₜ) das Ausgangssignal (S) erzeugt wird (53).

14. Verfahren nach einem der Ansprüche 12 oder 13, wobei das Ausgangssignal (S) einen von zwei möglichen Pegeln aufweist, in Abhängigkeit davon, ob die an den Eingangskontakten (2, 3) anliegende Versorgungsspannung (U₀) den vorgegebenen Schwellwert überschreitet oder nicht, und
- das Ausgangssignal (S) der Steuereinheit (CU) zugeführt wird (54), welche in Abhängigkeit von dem Pegel des Ausgangssignals (S) den Aktor (A) ansteuert.

15. Verfahren nach einem der Ansprüche 12 bis 14, wobei aus der auf dem zweiten Leitungspfad (P2) geführten Versorgungsspannung (U₀) durch einen ersten Gleichrichter (G1) eine erste gleichgerichtete Spannung (U_{G1}) erzeugt wird, aus welcher die integrierte Spannung (Uᵢₙₜ) erzeugt wird.
